Europäisches Patentamt

European Patent Office

Office européen des brevets

(11) Publication number: **0 335 113**
**A2**

# (12) EUROPEAN PATENT APPLICATION

(21) Application number: 89103323.5

(22) Date of filing: 24.02.89

(51) Int. Cl.⁴: **G06F 12/08**

The title of the invention has been amended (Guidelines for Examination in the EPO, A-III, 7.3).

(30) Priority: 26.02.88 JP 41990/88

(43) Date of publication of application:
04.10.89 Bulletin 89/40

(84) Designated Contracting States:
DE FR GB IT

(71) Applicant: **HITACHI, LTD.**
6, Kanda Surugadai 4-chome
Chiyoda-ku Tokyo 101(JP)

(72) Inventor: **Uchiyama, Kunio**
A-301, 2-32, Koyasucho
Hachioji-shi Tokyo(JP)
Inventor: **Aoki, Hirokazu**
1-48-18, Akatsukicho
Hachioji-shi Tokyo(JP)
Inventor: **Nishimukai, Tadahiko**
1-3-39, Nishi-Hashimoto
Sagamihara-shi Kanagawa(JP)

(74) Representative: **Strehl, Schübel-Hopf,
Groening, Schulz**
Maximilianstrasse 54 Postfach 22 14 55
D-8000 München 22(DE)

(54) **Single chip cache memory, and cache memory apparatus including a plurality of parallel connected single chip cache memories.**

(57) A single chip cache memory device can operate alone, and can operate together with like cache memory devices so that the overall cache memory capacity can be expanded by the number of devices connected in parallel, with each single chip cache memory device being self-constructed so as to contain circuitry to facilitate their parallel connection. When a plurality of single chip cache memory devices are connected in parallel to constitute a large memory capacity cache memory apparatus, the access to the main memory on a cache miss-hit is permitted only for the cache memory device having a code that coincides with the code portion of the address signal, and access to the main memory for the remainder for the cache memory devices during the miss-hit is inhibited. This is accomplished by providing a specific different code to each one of the cache memory devices connected in parallel.

FIG. 1

# CACHE MEMORY

## BACKGROUND OF THE INVENTION

The present invention relates to cache memories, which are high speed temporary memories located between a processor and a larger and slower main memory. The cache will temporarily store frequently used instructions and/or data from the main memory to increase the speed of processing, as disclosed in:
A 40K Cache Memory Management Unit, James Cho et. al., 1986 IEEE International Solid State Circuits Conference, Digest of Technical Papers, pages 50 and 51;
U.S. Patent 4,493,026 to Howard T. Olnowich, issued January 8, 1985; and
An 8K byte Intelligent Cache Memory, Takayuki Watanabe, 1987, IEEE International Solid-State Circuits Conference, digestive technical papers, pages 266 and 267 A cache memory, as a buffer memory, is well known as a technique to fill the gap between the machine cycle time of a microprocessor unit (MPU) and the slower operation cycle time of a main memory in a computer system to improve the performance. In a system using a MPU, the ,cache memory can increase the speed of the machine cycle, by increasing memory speed for frequently used data. Conventionally, the cache memory has been constituted by combining a plurality of general purpose RAM components and integrated circuits having a logic function. Recently, attempts have been made to constitute the cache memory by a single chip with the improvement in the integration density of the integrated circuits.

## SUMMARY

It is the intention of the present invention to provide cache memory in the form of an integrated circuit on a single chip, so that a cache memory of greater capacity can be easily obtained by connecting a plurality of such single chips in parallel to provide an expanded cache memory as desired.

In a cache memory device using a cache memory of a single chip, the number of transistors that can be integrated into the single chip cache memory is limited so that a memory capacity of a single chip cache memory is often insufficient. Therefore, it is desirable, according to the present invention, that the cache memory chip can operate singly as a cache memory apparatus, and further, when a plurality of such single chips are connected and parallel, an expanded cache memory apparatus having an increased memory capacity corresponding to the number of cache chips can be constituted.

It is the object of the present invention to provide a single chip cache memory device that can operate alone, and that can operate together with like cache memory devices so that the overall cache memory capacity can be expanded by the number of devices connected in parallel, with each single chip cache memory device being self constructed as to contain circuitry to facilitate their parallel connection.

In order to accomplish the above described objects, the present invention employs construction such that a code portion of the address signal from the processor, such as a MPU, coincides with a code of only one of the plurality of cache memory devices connected and parallel, so that access of only one of the parallel single chip cache memory devices to the main memory is accomplished by reading out instructions and/or data from the main memory and copying into the cache memory the instruction and/or data in the case of a cache miss-hit. When the specified code portion of the address signal does not coincide with the code of the other cache memories, such access of other cache memories to the main memory are inhibited during a cache miss-hit.

Even when the main memory access of the other cache memory devices is inhibited, when their code is not the code portion of the address from the processor, the memory operation of the instructions and/or data in the cache memory device are not inhibited but are maintained.

When the single chip cache memory device singly constitutes the cache memory apparatus, the access to the main memory in the case of cache miss-hit is permitted unconditionally.

When a plurality of single chip cache memory devices are connected in parallel to constitute a large memory capacity cache memory apparatus, the access to the main memory on a cache miss-hit is permitted only for the cache memory device having the code that coincides with the code portion of the address signal, and access to the main memory for the remainder for the cache memory devices during the miss-hit is inhibited. This is accomplished by providing a specific different code to each one of the cache memory devices connected in parallel.

If all of the cache memory devices connected in parallel are miss-hit for the address signal supplied from the processor, only the cache memory device having the code corresponding to the code portion of the address signal is permitted to make access to the main memory and the remainder of the cache memory devices not having a code corresponding to the code portion of the address signal are inhibited to make such access. Therefore, when a plurality of single chip cache memory devices are connected in parallel to constitute a large memory capacity cache memory apparatus, conflict or competition among these devices can be avoided.

BRIEF DESCRIPTION OF THE DRAWINGS

Further objects, features and advantages of the present invention will become more clear upon the following detailed description of preferred embodiments as shown in the drawing, wherein:

Fig. 1 is a block diagram showing the internal structure of a single chip cache memory device according to one embodiment of the present invention;

Fig. 2 shows the field structure of an address signal;

Fig. 3 is a wiring diagram for a plurality of cache memory chips according to Fig. 1 connected in parallel to constitute a cache memory apparatus having a large memory capacity;

Fig. 4 shows the internal structure of the cache control circuit 90 in the cache chip shown in Fig. 1;

Fig. 5 is a state shift diagram of the access control circuit 900 inside the cache control circuit 900 shown in Fig. 4;

Fig. 6 is a state shift diagram of an invalidation control circuit 901 in the cache control circuit 90 shown in Fig. 4;

Fig. 7 is a block diagram explaining the internal structure of a single chip cache memory device according to a second embodiment of the present invention;

Fig. 8 is a wiring diagram showing a plurality of cache chip devices according to Fig. 7 connected in parallel to constitute a large capacity cache memory apparatus; and

Fig.9 shows the internal structure of a selection circuit 1030 in the cache chip shown in Fig. 7.

DETAILED DESCRIPTION OF THE PREFERRED EMBODIMENTS

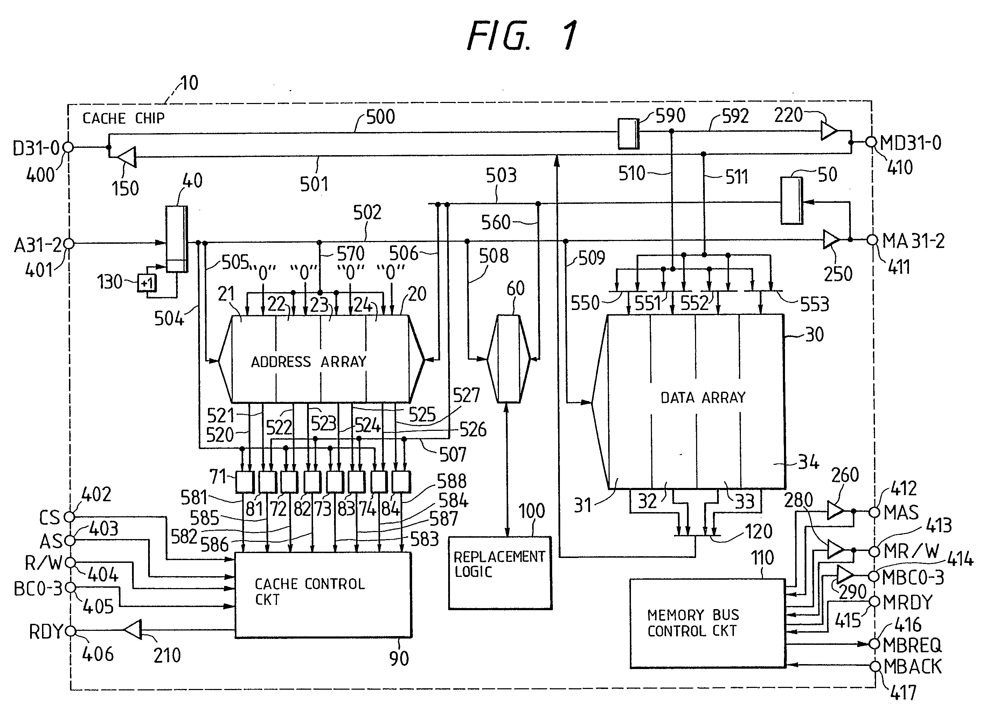

A first embodiment of the present invention will be described with reference to Fig. 1. This drawing shows the overall construction of a single chip cache memory device 10. Hereinafter, this device 10 will be referred to as the "cache chip".

This cache chip 10 is disposed between a processor 600 (Fig. 3) for processing instructions and/or data and a main memory 601 (Fig. 3) for storing the instructions and/or data, and operates individually as a cache memory apparatus, for example, having a 64 K-byte capacity. The basic data width is 4 bytes (32 bits) and a 4-GB (gigabyte) main memory space is supported as the address space.

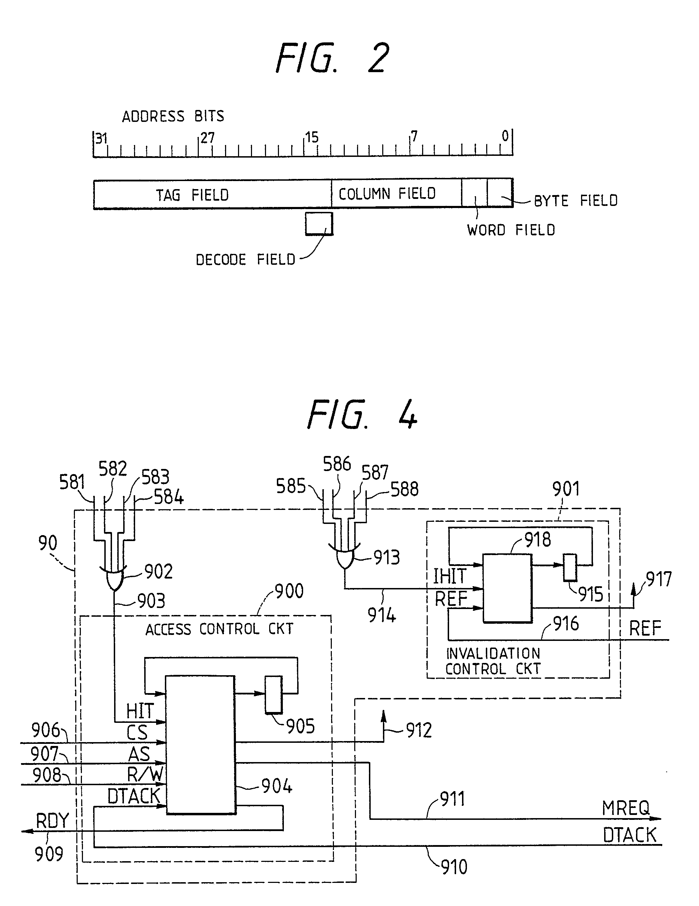

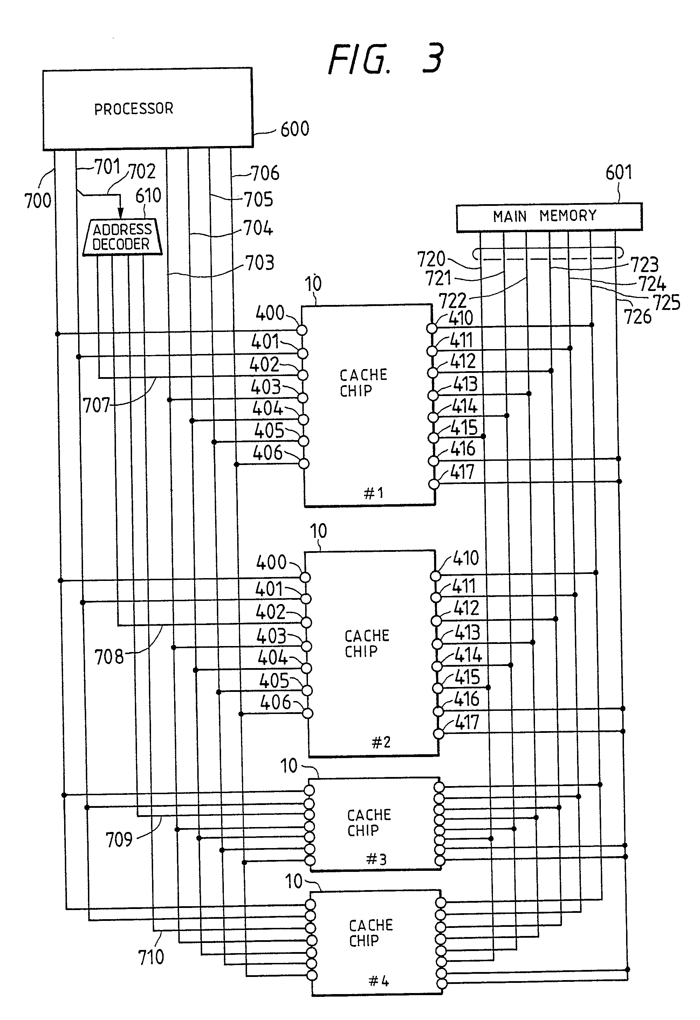

Generally, the main memory is divided into a large number of sectors, each sector is in turn divided into a large number of blocks and each block is divided into a plurality of words. Furthermore, each word is divided into a plurality of bytes. In the address signal of a plurality of bits that is generated from the processor, areas for designating the sector number, the block number, the word number and the byte number will be referred to as a "column field", a "tag field, a "word field" and a "byte field", respectively (see Fig. 2).

Broadly speaking, the cache memory chip 10 shown in Fig. 1 includes:

(1) a first terminal 401 for communicating the address (A31-2) with the processor;

(2) a second terminal 400 for communicating the instructions and/or data (D31-0) with the processor;

(3) a third terminal 411 for communicating the address (MA31-2) with the main memory;

(4) a fourth terminal 410 for communicating instructions and/or data (MD31-0) with the main memory;

(5) a first signal transmission path 502 between the first terminal 401 and the third terminal 411;

(6) a second signal transmission path 500, 501 between the second terminal 400 and the fourth terminal 410;

(7) first memory (data array 30) for storing temporarily the instructions and/or data stored in the main memory;

(8) second memory (address array20) for storing the information (tag field) related to the address of the instruction and/or data stored in the first memory;

(9) first detector 71-74 for detecting the relation (hit or miss-hit) between the information (tag field) stored in the second memory 20 and the address signal (tag field) supplied from the first signal transmission path 502;

(10) control circuit 90,110 for transmitting the instructions and/or data stored in the first memory 30 to the processor through the second signal transmission path 501 and the second terminal 400 in response to the detection result of the first detector 71-74, when the relation between the information (tag field) stored in the second memory 20 and the address signal (tag field) supplied from the first signal transmission path 502 is under a fixed state (at the time of hit), and for reading out the instructions and/or data related to the address signal from the main memory (making access to the main memory) in response to the miss-hit detection result of the first detector 71-74 and for transmitting the instructions and/or data to the processor 600 through the second signal transmission path 500 and the second terminal 400 and for storing also them in the first memory 30; and

(11) terminal 402 for receiving a control signal CS from outside the cache chip 10 and transmitting it to the control circuit 90-110;
wherein when the control signal CS is under a fixed condition, the control circuit 90, 110 inhibits at least one of operations of read-out of the instructions and/or data from the main memory and of write-in of the read information into the first memory 30 and during this inhibit operation, the memory operations of the first and second memory 30, 20 are maintained.

In the address signal shown in Fig. 2 as having a plurality of bits, which is generated from the processor, the signal of the column field is supplied to the second memory 20 through the first transmission path 502 and line 505. This column signal becomes a cache search input signal and the tag fields stored in memory 20 at the column position corresponding to the input column field become cache search output signals and are taken out from output lines 520, 522, 524, 526, of the second memory 20. A validity bit signal representing whether or not each tag field signal is valid is taken out simultaneously from the output lines 520, 522, 524, 526. The tag field signals thus taken out from the output lines 520, 522, 524, 526, are compared by the first detector 71-74 with the signal of the tag field supplied from the processor through the first signal transmission path 502 and the line 504 to judge hit and miss-hit. In the case of cache hit, the corresponding instructions and/or data stored in the first memory 30 are transmitted to the processor through the second signal transmission path 501, the transmission device 150 and the second terminal 400.

When the cache chip 10 singly constitutes the cache memory apparatus, the control signal CS, e.g., chip select, transmitted to the control circuit 90,110 is always set to the fixed condition that does not inhibit the read-out operation of the instructions and/or data from the main memory and the write-in operation of the read information into the first memory 30.

When a large capacity cache memory apparatus is constituted by connecting in parallel a plurality of cache chips 10 as shown in Fig. 3, a specified code is allotted to each cache chip 10. For example, four cache chips may be connected in parallel as shown in Fig. 3, although any number of cache chips may be suitably connected according to the present invention. With four chips, two bits may be used to provide a code that specifically identifies each of the four chips. For example, chip number 1 would be identified by the code 00, chip number 2 identified by the code 01, chip number 3 identified by the code 10, and chip number 4 identified by the code 11. This code would be a code portion within the field of the address signal, and is specifically shown as the de-code field, bits number 14 and 15 in Fig. 2. With more than four cache chips, more than 2 bits would be required for the de-code field, and correspondingly with only two cache chips the de-code field could be of a one bit length.

The write-in operation of the information read-out from the main memory into the first memory 30 is only permitted to the cache chip whose specified code is coincident with the specified decode field bits (A15, A14) of the address supplied from the processor in the tag field. These operations are inhibited for the rest of the cache chips not exhibiting this coincidence. The reason is as follows:

When the address is generated from the processor in order to read out the instructions and/or data from the main memory or the cache memory apparatus, the following memory operations are carried out in all the cache chips 10 connected in parallel;

(1) address search of the column field of the second memory (address array 20);

(2) read-out of the tag field from the second memory (address array 20) by the address search described above; and

(3) judgment of cache hit and miss-hit by the comparison of the tag field read out as described above with the tag field generated by the processor.

In the case of cache "hit", only one of the plurality of cache chips 10 has a real cache hit and the information read out from its first memory (data array 30) is transferred to the processor 600.

The other cache chips that do not have a hit are inhibited from reading out their information from their first memory.

In the case of cache "miss-hit", however, miss-hit can occur for all the cache chips 10. In this case it is not efficient if all these cache chips 10 execute the information read-out from the main memory and transmission of the read information to the processor 600 (not the present invention). Furthermore, storage of the information read out from the main memory in the first memory (data array 30) of all cache chips 10 makes parallel connection of a plurality of cache chips 10 meaningless.

For the reasons described above, in the embodiment shown in Fig. 3, the information read-out operation from the main memory and the write-in operation of the read information into the first memory 30 is permitted for only one chip among the plurality of cache chips 10 in response to the specified code bits A15, A14 of the address signal generated from the processor in the case of cache miss-hit, and these operations are inhibited to the rest of chips.

In the case of cache hit, signal transmission of the transmission device 150 of the cache chip 10 having a cache hit is permitted in response to the specified code bits A15,14 described above, and the information read out from the first memory 30 is transferred to the processor 600. Signal transmission of the transmission device 150 of the rest of cache chips 10 not involving in a cache hit is inhibited. Accordingly, the information transferred from the cache chip 10 exhibiting a cache hit to the processor 600 is not disturbed.

On the other hand, the instructions and/or data stored in the main memory 601 are often re-written by an I/O device or a processor [e. g., a processor different from the processor 600 also connected (not shown) to main memory 601]. If such information re-write occurs, the data already stored in the cache memory and having the same address as the address of re-write information is invalidated.

To execute this invalidation operation, the cache chip shown in Fig. 1 further includes, referring to the list of elements above:
(12) second detector 81-84 for detecting the correlation (hit or miss-hit) between the information (tag field) stored in the second memory 20 and the external address signal (tag field) supplied from outside the cache chip 10 to the third terminal 411; wherein the control circuit 90, 110, to invalidate the information, resets the validation bit to 0 in the tag field stored in the second memory 20 in response to the information (MR/W) on terminal 413 indicating a write cycle and to the second detector 81-84 if the relation described is under the hit condition. When the other processor or I/O apparatus writes data to the main memory, the information MR/W on terminal 413 is negated.

Hereinafter, one embodiment of the present invention will be described in further detail with reference to Figs. 1 to 6.

With a plurality of cache chips 10 connected in parallel to constitute a large memory capacity cache memory apparatus as shown in Fig. 3, a control signal generator 610 generates a control signal (CS) for selecting only one of the plurality of cache chips 10 in response to the specified decode bits A14 and A15 in the tag field of the address supplied from the processor. The signal generator is a single decoder 610 located outside the cache chip 10.

Fig. 1 is a block diagram showing in detail the internal structure of one cache chip 10 of a plurality. An address array 20 for storing the address tag information and a data array 30 for storing instructions and/or data are placed inside the cache chip 10. The address array memory 20 consists of four sets of 2-port RAMS 21, 22, 23, 24 although any number may be employed, each being of 1,024 words by 19 bits type. The data array memory 30 consists of four sets of RAMs 31, 32, 33, 34 corresponding in number to the number of sets of the address array 20, each being of 4,096 words by 32 bits type. Each cache chip 10 constitutes alone a 4-way set associative system cache memory having the number of columns of 1,024 and a block length of 16 bytes by use of these two arrays 20 and 30. A similar system is shown in USP 4,493,026 whose disclosure is incorporated herein and is in more detail. The store method used in this cache chip is a store-through method which always updates the content of the main memory at the time of storing data.

The cache chip 10 is connected to the processor through signal pins 400-406 on the left side and is further connected to the main memory bus and optionally another processor or I/O device through signal pins 410-417 on the right side. The address space supported by the cache chip is 4 GB (gigabyte; 32-bit address). The upper order 30 bits are inputted from the processor side to the address signal pins (A31-A2) 401 and a byte control signal in the decoded form of the lower two bits A1, A0 is inputted from the pins (BC0-BC3) 405. The signal inputted from the byte control signal pin 405 contains the information on the data length in addition to the information of the lower two bits A1, A0 of the address. Assuming, for example, that one word consists of four bytes and access is made simultaneously to the data of the third and fourth bytes in one word, a logic "I" appears at the byte control signal pin 405 in the form BC0 = 0, BC1 = 0, BC2 = 1 and BC3 = 1 (that is in the form corresponding to the byte position to which access is made in practice) and is inputted to the cache chip 10.

The upper order 30 bits of the address signal outputted from the processor are inputted to the address signal pins (A31-A2) 401 of the cache chip 10 and the value is held in an address hold register 40. At the same time, it flows to an internal address bus 502 of a 30-bit width in the chip. Each bit of the address is allotted to the field such as shown in Fig. 2. The bits from the thirteenth bit to the fourth bit are allotted as a column field. The portion on the internal address bus 502 corresponding to the column field is inputted as an address search input to the input of the address array 20 through the line 505 and a plurality (four in this embodiment) of address tags stored in the column corresponding to this search input is read out through the output lines 520, 522, 524, 526. The line 520 is an address tag read line from the first set 21 of the address array 20; line 522 is an address tag read line from the second set 22; line 524 is an address tag read line from the third set 23; and line 526 is an address tag read line from the fourth set 24. Each address tag read line is of 19-bit width. The content of these 19 bits consists of the 18 bit address tag A31-A14 and 1-bit validity bit. The address tag information read out from each set of address tags corresponding to a column match is inputted to each corresponding comparator 71, 72, 73, 74 and is compared with the value on the tag field (Fig. 2) from the 31st bit to the 14th bit on the internal address bus 502 inputted to each comparator. When the comparison result proves to be coincident for one of the comparators 71-74 and moreover if also the validity bit is 1, a corresponding hit signal 581, 582, 583 or 584 is asserted and reported to a cache control circuit 90. The state where any one of these hit signals 581, 582, 583, 584 is asserted corresponds to the state of cache hit for the cache chip and represents that a desired (according to the processor sent address) block (16 bytes) is stored in the data array 30.

The content of the data array 30 is read out by the information on the signal line 509 in parallel with the address array 20. The values of the column field and word field shown in Fig. 2 ( among the address bits) flow to the signal line 509. Four blocks, each having a 16-byte length, (corresponding to four words) are respectively inside four sets 31, 32, 33, 34 for each column field and 4 bytes (that is, one word) among the 16 bytes are selected by the word field. Four x 4-byte data are read out from each set 31, 32, 33, 34. If the cache hit state is known at this time or in other words, if any one of the hit signals 581, 582, 583, 584 is asserted, the 4-byte data read out from the set of the corresponding data array 30 are selected by the selector 120 from that information; its value flows to the internal data bus 501 and the data are delivered from the data pin (D31-DO) 400 to the processor.

On the other hand, if the cache hit is not established as a result of search and comparison of the address array 20, the cache chip fetches the 16-byte long block by four times fetch including the 4-byte word containing the necessary data from the main memory 601 in accordance with the address information held by the address hold register 40 and the data are inputted from the memory data signal pin 410 and flow to the internal data bus 501. Among the 16-byte data inputted, the requested 4 bytes are passed from the data signal pin 400 on the processor side to the processor and at the same time, are written into one of the four ways 31, 32, 33, 34 of the data array 30 through the data bus 511 and the selectors 550, 551, 552, 553.

The information for selecting the ways is obtained from the information stored in a replacement memory 60. This replacement memory 60 is a 2-port RAM of 1,024 columns by 6 bits, and the information of each 6 bits contains the information determining in which way of the data array 30 the new block is to be stored at the time of block transfer. The content of this replacement memory 60 is searched by the value of the column field that flows from the bus 508 simultaneously with the searching of the address array 20 and is replaced by a well known LRU (Least Recently Used) algorithm through a replacement logic 100.

This LRU algorithm is reported in 1987 IEEE International Solid-State Circuits Conference DIGEST OF TECHNICAL PAPERS, pp. 266-267 whose disclosure is incorporated herein. In the block transfer in the 16-byte unit (that is, 4-word unit) described above, the 12-byte data from the second to fourth words are not transferred to the processor but are only re-written in the data array 30. In the interim, the portion of the tag field (see Fig. 2) among the address for the newly transferred block is written through the bus 570 into one of the ways 21, 22, 23, 24 corresponding to one of the ways 31, 32, 33, 34 where the block is stored. Simultaneously with storing the tag field in memory 20, the validity bit representing the validity of the data is set to "I" and written into the same place.

A " + I" incrementer 130 is added to the lower two bits A3-A2 of the address hold register 40 and operates as a 2-bit counter. Here, the word address inside the block of the address held by the address hold register 40 is updated during block transfer. In other words, since the block transfer described above is made for the 4-word unit, the incrementer 130 counts up by +I after the data for one word that is taken in and then shifts to the data reception of the next one word. Therefore, after the complete block transfer of the 4-word unit, the incrementer has counted up by a total of +3. The address for the main memory is sent to the main memory through the signal pins (MA31-MA2) 411 terminal of the output buffer 250.

The register 590 is a buffer which stores once the values of the instruction and/or data when the processor writes them into main memory. Since this cache chip 10 employs the store-through method, the data inside the register 590 is written into the data array 30 through the bus 510 and one of the selectors 550, 551, 552 or 553 when the address array 20 is searched and hit or otherwise in accordance with replacement logic 100. The data is written into the main memory from the signal pin 410 through the path 592 and the output buffer 220.

In other words, the registers 40 and 590 operate as a store buffers when the data is written into the main memory. When the processor writes the data into the main memory through the cache chip 10, the processor writes the write address into the register 40 and the write data into the register 590. If the main memory is busy, then the processor shifts to the next operation by assuming the write operation into the main memory is complete. Thereafter, since the cache chip 10 outputs consecutively a memory bus request signal MBREQ 416, the data held by the register 590 is written into the main memory only after a memory bus acknowledge signal MBACK 417 is asserted when the main memory is no longer busy.

As has been described partially in the foregoing, interface signal pins are disposed between the processor and the cache chip 10 on the left side of Fig. 1 and interface pins are disposed between the cache chip 10 and the main memory bus on the right side of the drawing. Reference numeral 400 represents a data bus signal pin with the processor and 401 an address pin for receiving the upper order 30 bits of the address from the processor. Symbol CS402 represents a chip select pin of the cache chip 10 and when "I" is applied to this signal pin CS402, the inside of the cache chip 10 operates completely and when "0" is applied, part of the operation inside the chip is inhibited as described before. This signal pin CS402 makes it possible to expand the apparatus to include other parallel cache chips 10. When the cache chip 10 is used alone or singly, "I" is always inputted to this pin CS402. Symbol AS403 represents an address strobe signal pin. Logic "I" is inputted to this pin AS403 when the valid address is inputted to 401 and "0" is inputted at other times. R/W 404 represents an input pin for discriminating the read (R/W = 1) and write (R/W = 0) requests from the processor and input is made at the same timing as the address 401. BC3-BC0 designate the byte positions of the write and read data. RDY406 represents a pin which lets the processor know that the read or write cycle is finished, and the signal is outputted through the output buffer 210.

Next, the interface pins for the main memory bus of the cache chip 10 will be described. (MD31-MD0) 410 are bi-directional data bus pins of a 32-bit width. (MA31-MA2) 411 are bi-directional memory address bus pins through which the upper order 30 bits of the memory address pass. MAS412 is an address strobe signal pin of the memory bus, and "I" is applied to this signal pin when the valid memory address is passed on 411. When "I" is inputted to this signal pin, it represents that the valid address exists on the memory address pin 411. MR/W 413 is a pin for inputting and outputting a signal for discriminating the read MR/W = I and write MR/W = O requests from and to the main memory. (MBC3-MBCO) 414 are signal pins to designate the byte positions of the data. MRDY415 is a pin to whioh a signal reporting that the bus cycle of the main memory is complete is inputted. Output buffers 260, 280, 290 are respectively for pins 412, 413, 414.

In the main memory read cycle, the instructions and/or data are inputted from the main memory to 410 and at the same time, a ready signal is returned from the main memory to the signal pin 415. MBREQ416 is a signal requesting the use of the main memory bus and when the cache chip 10 needs to use the main memory bus, "I" is outputted from this pin and requests the use to an external bus arbiter. As a result, if the main memory bus becomes usable, an external bus master outputs a permission signal to the cache chip 10, which is inputted from the input pin MBACK417. In this manner, the cache chip 10 can now use the main memory bus.

The signal pins 410, 411, 412, 413, 414, 415 are commonly connected to the corresponding signal pins of the device which can be a bus master on the main memory bus. Therefore, when the cache chip does not use the main memory bus, the output buffers 220, 250, 260, 280, 290 are turned off and the corresponding signal pins 410, 411, 412, 413 become the input pins while the signal pin 414 is under the high impedance state. When the cache chip 10 does not use the main memory bus as described above, the cache chip 10 watches the bus cycle on the main memory. This bus watching function is a mechanism such that when the content of the main memory is re-written by other bus masters (that is, other processors or I/O apparatus), the content of the cache in the cache chip 10 is searched and if there exists any block having the same address, it is invalidated.

Invalidation of the cache described above is effected in the following way. When "I" is inputted from MAS412 and "O" (write) is inputted from the MR/W413, the address from MA31-MA2 411 is latched by the register 50. This value flows on the cache invalidation address bus 503 and the value of the column field of the address (Fig. 2) is used as the search input address through the path 506 in order to read out the desired tag of the address array 20. The four tags 521, 523, 525, 527 thus read out are compared with the value (the value on the path 507) of the tag field (Fig. 2) of the address of the write cycle of the main memory bus by the corresponding four comparators 81, 82, 83, 84, respectively, and the results of comparison are outputted to the cache control circuit 90 as the hit signals 585, 586, 587, 588. If "I" exists on any of these hit signals, the tag information of the address stored in the column designated by the set corresponding to that hit signal is invalidated. Therefore, "O" is written into the validity bit of that position. At the same time, the replacement information of the replacement memory 60, to which access is made by the value of the same column field flowing from the path 560 is updated in accordance with this invalidation.

This cache chip 10 not only operates by itself as a cache memory apparatus of a 1,024 columns by 4 sets associative system by fixing the CS402 input pin to "I" but its memory capacity can also be expanded easily with other like parallel cache chips by inputting the decoding result of part of the address information to the CS402 input pin.

Fig. 3 shows an example of the cache memory apparatus of a set associative system having 256 KB and 4,096 columns by 4 ways as a whole by connecting four cache chips 10. The data bus 700 with the processor 600 is connected to the data pin 400 of each cache chip 10. The address signal 701, address strobe signal 703, read/write request signal 704 and byte control signal 705 generated by the processor 600 are connected to the input pins 401, 403, 404 and 405 of each cache chip 10, respectively. The output from RDY406 of each cache chip 10 is subjected to wired-OR and connected to the ready signal 706 of the processor 600. The 15th and 14th bits of the address signal 701 generated from the processor 600 becomes the decode field (Fig. 2) and inputted to the 2-bit decoder 610 through a path 702, and its four decode outputs 707, 708, 709, 710 are inputted to the chip select pin CS402 of each cache chip.

The output of the output buffer 150 connected to the data pin 400 in Fig. 1 is ENABLE only for the cache chip 10 selected by the chip select signal CS402 and is under the high impedance state at other chips. The output of the output buffer 210 connected to RDY406 is ENABLE only for the cache chip selected by the chip select pin CS402 and is under the high impedance state at other chips.

As shown in Fig. 3, on the other hand, the data bus 725, address bus 724, address strobe signal 723, read/write signal 722, byte control signal 721 and ready signal 720 of the main memory bus are connected commonly to the corresponding pins 410, 411, 412, 413, 414 and 415 of each cache chip 10 respectively. The bus request signal outputted from MBREQ416 of each cache chip 10 is sent separately to the bus arbiter of the main memory bus and a separate bus acknowledge signal is inputted to MBACK417 as the reply corresponding to it. The signal 726 of the main memory bus is a group of a plurality of these signals.

In Fig. 3, among the outputs of the 2-bit decoder 610 for decoding the 15th bit A15 and 14th bit A14 of the address, the output 707 becomes "I" only when A15 = 0 and A14 = 0, 708 is "I" only when A15 = 0 and A14 = I, 709 is "I" only when A15 = I and A14 = 0 and 710 is "I" only when A15 = I and A14 = I, and the corresponding cache chip 10 is selected. As a result, the value of the 15th and 14th bits (lower order 2 bits) of the valid address tag stored in the address array 20 inside the first cache chip #I in Fig. 3 becomes always 00, the value of the second cache chip #2 is 01, the value of the third cache chip #3 is 10 and the value of the fourth cache chip #4 is 11. Accordingly, there does not occur a case where the valid address tag having the same value exists in the address arrays 20 of a plurality of cache chips 10. For this reason, when the processor 600 fetches the data, at most one chip is hit even though the address arrays 20 of all the cache chips 10 are searched. When no chip is hit, one cache chip 10 selected by the chip selects 707, 708, 709, 710 makes block transfer with the main memory to deliver the data to the processor and stores the block in the selected cache chip 10. When the processor 600 stores the data in the main memory, the selected cache chip 10 plays the role of storing the data in the main memory. Furthermore, all the cache chips 10 watch the address of the main memory bus regardless of whether or not they are selected by the decoding result of the address of the processor 600.

In Fig. 1, two state machines operating independently exist inside the cache control circuit 90. Fig. 4 shows the two state machines inside the cache control circuit 90. An access control circuit 900 controls cache access from the processor side and an invalidation control circuit 901 is for invalidating the entry of the cache, whenever necessary, by watching the address on the main memory bus.

The input signals to the access control circuit 900 are CS906 inputted from the chip select pin 402 of the cache chip 10, AS907 inputted from the address strobe pin 403, R/W908 inputted from the read/write pin 404 and the data acknowledge signal DTACK910 from the memory bus control circuit 110. Another input signal is HIT903 obtained by the output of OR gate 902 of the hit signals 581, 582, 583, 584 of each way as the result of search of the address array 20 for the access from the processor. Its output signals include various control signal groups 912 for controlling the cache, MREQ911 requesting the memory bus control circuit 110 to make access to the main memory, and RDY909 connected to the ready signal pin 406 through the output buffer 210. Each input signal is inputted to the combination circuit 904 with the present state information to generate the output signal, and also generates the next state. Reference numeral 905 represents a flip-flop group for holding the state.

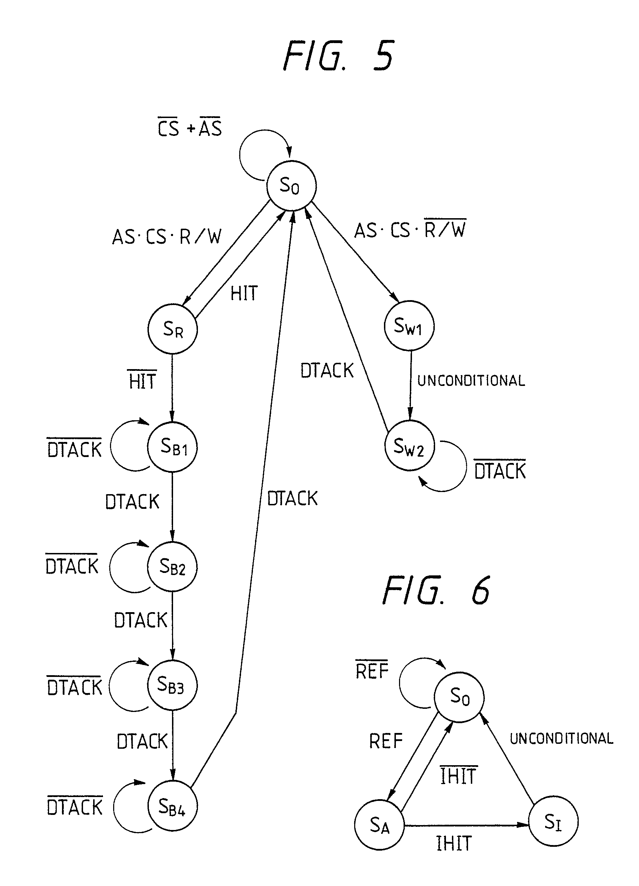

This flip-flop group 905 holds the information corresponding to various states $S_0$, $S_R$, $S_{BI}$ - $S_{B4}$, $S_{WI}$, $S_{W2}$ of the later-appearing access control circuit 900 shown in Fig. 5.

One of the input signals of the invalidation control circuit 901 is an invalidation hit signal 914 "IHIT" for invalidation which is obtained by the output of OR gate sum 913 of the hit signals 585, 586, 587, 588 of each way as the result of search of the address array 20 by the address on the main memory bus.

Another input signal REF916 is the signal from the memory bus control circuit 110. When another bus master executes the write-in of data to the main memory via the main memory bus, that is, when "I" is inputted from the address strobe signal pin MAS412 and "O" is inputted from the read/write signal pin MR/W413, "I" flows to this REF 916 and instructs the control circuit 901 (described later) to search the address array 20 for invalidation. Reference numeral 918 represents a combination circuit and reference numeral 915 represents a flip-flop group for holding the state. This flip-flop group 915 holds the information corresponding to various states $S_0$, $S_A$, $S_1$ of the later-appearing invalidation control circuit 901 shown in Fig. 6, and reference numeral 917 represents a control signal group of the array 20 for invalidation. Fig. 5 shows the shift of the state of the access control circuit 900. $S_0$ represents the initial state, where the address array 20 is searched by the address from the processor 600 and its result is reflected on the hit signal HIT903. So long as $CS906 = O$ or $AS907 = O$, the state remains the state $S_0$. When $AS907 = I$ and $CS906 = I$ and moreover, $R/W = I$, that is, when the data fetch start is raised from the processor 600 and the cache chip 10 is selected by the chip select, the state shifts to the state $S_R$, thereby making the hit judgment. As a result, if hit is established ($HIT903 = 1$), "I" is returned to RDY909 together with the data from the data array 30, the data inside the cache is delivered to the processor 600 and the state returns again to the initial state $S_0$. If hit is not established ($HIT903 = 0$), the state shifts from $S_{BI}$ to $S_{B2}$, $S_{B3}$, $S_{B4}$ in order to request the block for the main memory. When the state shifts from $S_R$ to $S_{BI}$, "I" is delivered to MREQ911 and requests the memory control circuit 110 to fetch the data of the four bytes corresponding to the first word from the main memory. When the data is delivered from the main memory to the cache chip 10, the memory control circuit 110 delivers "I" to DTACK910 and notifies it to the access control circuit 900. Accordingly, that data is stored in the data array 30 and at the same time, the data is also sent to the processor 600 and "I" is delivered to RDY909 to notify it. The state shifts from $S_{BI}$ to $S_{B2}$ simultaneously with the reply of this DTACK910 and "I" is again delivered to MREQ911 in order to request the data of the four bytes of the second word in the block for the main memory to wait for the reply of DTACK910. Thereafter, the state proceeds from $S_{B2}$ to $S_{B3}$, $S_{B3}$ to $S_{B4}$ and further from $S_{B4}$ to $S_0$ in the same way as above and the data of the twelve bytes from the second and fourth words in the block are stored in the data array 30. However, this 12-byte data is not transferred to the processor 600 and only the data of the four bytes of the first word are transferred to the processor.

The case where $AS907 = I$, $CS906 = I$ and $R/W = 0$ is the case where the cache chip 10 is selected when the processor 600 stores the data in the main memory. In this case, the state shifts from $S_0$ to $S_{W1}$, "I" is delivered to RDY909 and the processor 600 finishes its cycle by understanding as if the data store is complete. At this time the address of the store data and the data value are held merely by the address hold register 40 and the data hold register 590, respectively, but are not yet written into the main memory. Next, when the state shifts from $S_{WI}$ to $S_{W2}$, "I" is delivered to the memory bus control circuit 110 through MREQ911, the write request for the main memory is raised and the reply of DTACK910 is awaited under the state $S_{W2}$. When the reply is received, the state returns from $S_{W2}$ to the initial state $S_0$. Since the cache chip 10 of this embodiment is of the store-through method, search of the address array 20 is effected in the case of store, too, and if hit is established, the corresponding data is updated under the state $S_{w1}$ or $S_{w2}$.

Fig. 6 shows the state shift diagram of the invalidation control circuit 901. $S_0$ represents the initial state, where the address array 20 is searched by the address on the main memory bus and the result is reflected on the hit signal IHIT914 for invalidation. When another bus master actuates the data write cycle for the main memory, "I" and "O" are inputted from MAS412 of the cache chip 10 and from MR/W 413, respectively, the memory bus control circuit 110 delivers "I" to REF916 in response to these input signals and actuates the invalidation control circuit 901. Accordingly, the state shifts from $S_0$ to $S_A$ to judge IHIT914. If IHIT914 is "O" (in the case of miss-hit), the state returns to the initial state $S_0$ but in the case of IHIT914 = I (in the case of hit), the state shifts to $S_1$ and the control signal for invalidating the hit block is sent from 917. This invalidation is made by writing "O" to the validation bit of the address array 20. Thereafter, the state returns to $S_0$.

The access control circuit 900, the invalidation control circuit 901 and the memory bus control circuit 110 operate in the manner described above, and the access control circuit 900 remains in the initial state $S_0$ and the state shift is inhibited so long as the chip select signal CS402 is not asserted.

Therefore, even when a plurality of cache chips are used and one of them is selected and access is made thereto from the processor, the other chips watch the address on the main memory bus and can make invalidation of the cache or can write the data of the store buffer in the chip into the main memory.

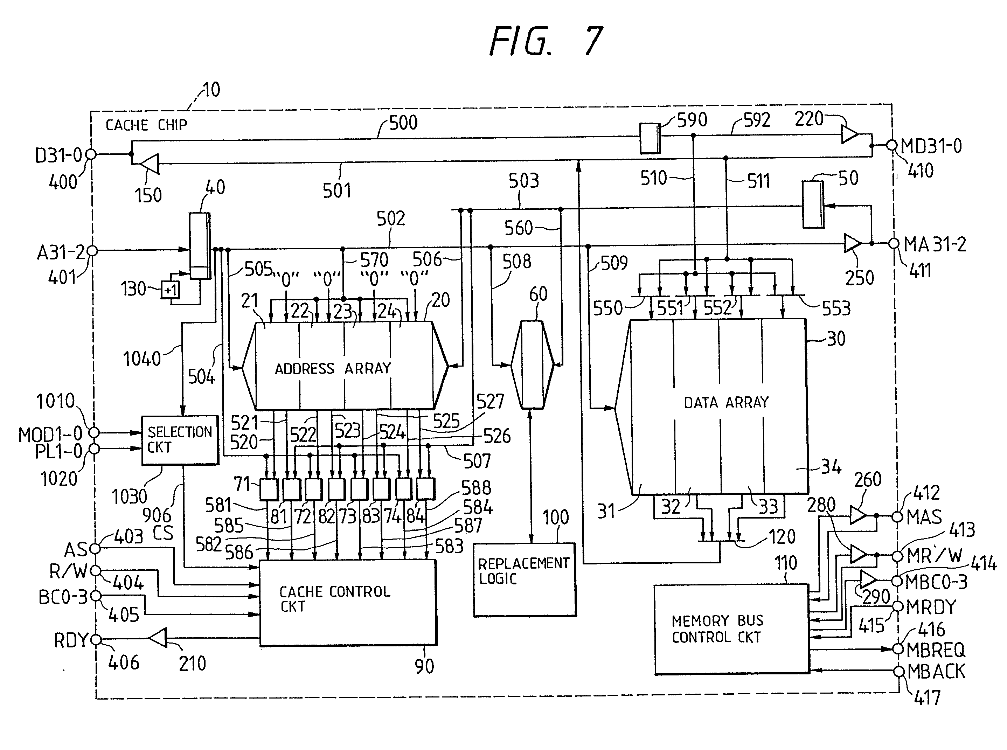

Next, another embodiment of the present invention will be described with reference to Figs. 7 to 9. The explanation will be omitted about the same circuit portions as those of the embodiment shown in Figs. 1 to 6 and only different portions will be described in detail.

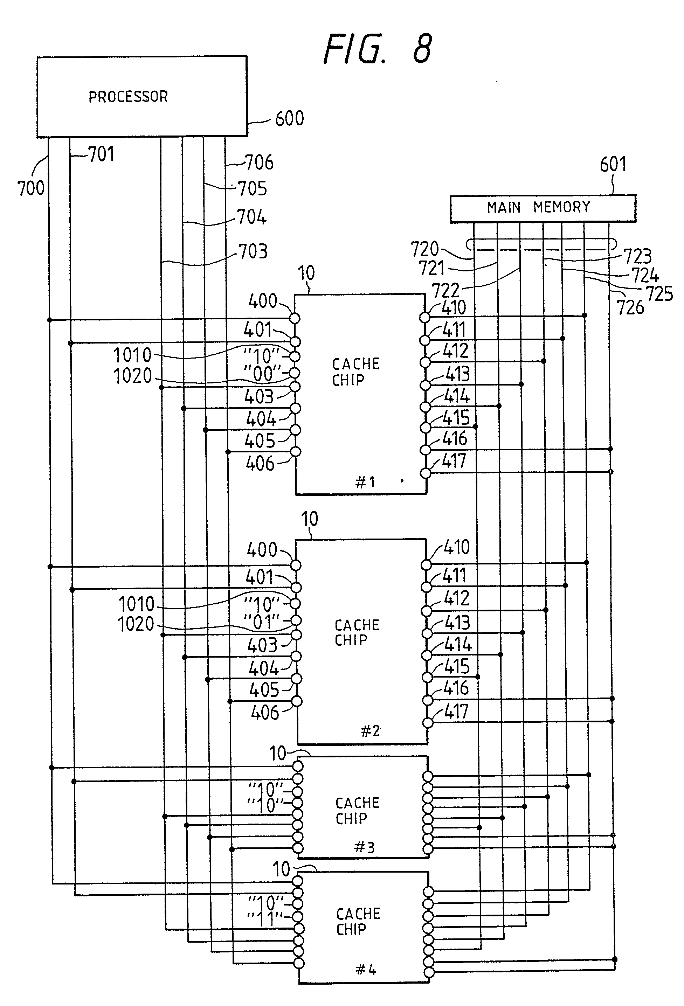

The basic characteristic feature of the embodiment shown in Figs. 7 to 9 resides in that control signal generator selection circuit 1030 for generating a control signal (CS) for selecting any one of a plurality of cache chips 10 in response to the specified bits (A15, A14) of the address supplied from the processor is disposed inside each cache chip (10) (see Figs. 7 and 8).

Hereinafter, Fig. 7 will be described in detail.

Reference numeral 1010 (MOD-0) represents a mode pin which instructs whether or not the cache chip 10 should be used singly. In this embodiment two pins are disposed and three structural modes exist. When the system is constituted by the single cache chip 10 alone, the input is fixed to MOD = 0 and MOD = 0. On the other hand, when two cache chips 10 are connected, the input is set to MOD = 0 and MOD = 1 and when four chips are connected, MOD = 1 and MOD = 0. Reference numeral 1020 (PLI-0) represents pins which is inputted by the position information of each cache chip 10 to be used when the signal pin 1010 instructs the structure consisting of a plurality of cache chips 10. When the signal pin 1010 instructs the 2-chip structure (MOD = 0, MOD = 1), "O" (first) is inputted to the PLO of the pin 1020 of one cache chip 10 and "I" (second) is inputted to PLO of the other cache chip 10. When the signal pin 1010 designates the 4-chip structure (MOD = I, MOD = O), "O" is inputted to PLI and PLO of the pin 1020 of the first cache chip 10, respectively. PLI = 0 and PLO = I for the second chip, PLI = I and PLO = O for the third chip and PLI = 1 and PLO = I for the fourth chip. The values inputted from 1010 and 1020 are inputted to the selection circuit 1030 together with the values of the 15th and 14th bits of the address bits from the processor (A15, A14) on line 1040 and the chip selection signal 906 (CS) is generated on the basis of this information. This signal CS906 is the one that determines whether the cache chip 10 is to be operated or not in accordance with the access request from the processor.

When the input of the pin 1010 is "OO" ( single structure mode), the value on CS906 is "I" and the state is the one where the cache chip 10 is always selected. When the input of the pin 1010 is "OI" (2-chip structure), the PLO input of the pin 1020 and A14 (14th bit) of the address bits are compared and when they are coincident, the value on CS906 is "I" and the cache chip 10 is selected. When the input to the pin 1010 is "IO" (4-chip structure mode), the PLI and the PLO inputs of the pin 1020 and the address bits A15, A14 are compared, and when they are coincident, the value of CS906 becomes "I" and the cache chip 10 is selected.

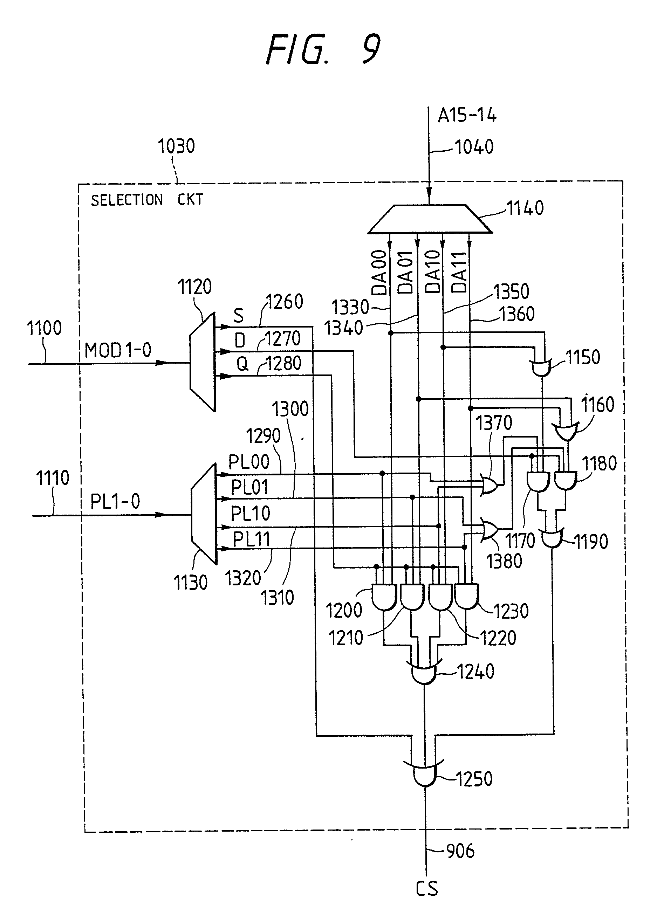

Fig. 9 shows the internal logic of the selection circuit 1030 accomplishing the functions described above. Reference numeral 1100 represents an input signal from pin 1010 and reference numeral 1110 represents an input signal from pin 1020. 1120, 1130 and 1140 represent 2-bit input decoders; 1170, 1180, 1200, 1210, 1230 are AND gates; and 1150, 1160, 1190, 1370, 1380, 1240 and 1250 are OR gates. The output signal 1260 of the decoder 1120 becomes "I" in the case of the single structure mode, the output signal 1270 is "I" in the case of the 2-chip structure mode and 1280 is "I" in the case of the 4-chip structure mode. The output signal 1290 of the decoder 1130 is "I" when PLI = 0, PLO = O, the output signal 1300 is "I" when PLI = 0 and PLO = I, the output signal 1310 is "I" when PLI = I and PLO = O and the output signal 1320 is "I" when PLI = I and PLO = I. The output signal 1330 of the decoder 1140 is "I" When A15 = O and A14 = O, the output signal 1340 is "I" when A15 = 0 and A14 = I, the output signal 1350 is "I" when A15 = I and A14 = 0 and the output signal 1360 is "I" when A15 = I and A14 = I.

Fig. 8 shows a wiring diagram for expanding the memory capacity by connecting in parallel four cache chips 10, where the control signal generation means (610) shown in Fig. 3 can be omitted because each chip will have the select circuit 1030 of Fig. 7.

In fig. 8, "10" (MOD = I, MOD = O) is fixedly inputted to the structure mode pin 1010 of each cache chip 10 to designate the 4-chip structure, "00" is inputted to the position information pin 1020 of the first cache chip 10 (#1), "01" to the second cache chip 10 (#2), "10" to the third chip (#3) and "II" to the fourth chip (#4). In this manner, since the mutually different position information are designated to each cache chip 10, CS906 of any one of the cache chips 10 becomes "I" (or that cache chip is selected) and two or more cache chips are not selected simultaneously by the access request from the processor 600.

While the present invention has been set forth with respect to embodiments, variations and modifications and the importance of such details other embodiments, variations and modifications are contemplated according to the spirit and scope of the following claims.

## Claims

1. A single chip cache memory device formed on a single semiconductor chip, for constituting a cache memory apparatus to be disposed between a processor for processing instructions and/or data and a main memory for storing said instructions and/or data, said single chip cache memory device comprising;
first terminal means for communicating an address with the processor;
second terminal means for communicating instructions and/or data with said processor;
third terminal means for communicating the address with said main memory;
fourth terminal means for communicating the instructions and/or data with said main memory;
a first signal transmission path between said first terminal means and said third terminal means;
a second signal transmission path between said second terminal means and said fourth terminal means;
first memory means for storing temporarily said instructions and/or said data stored in said main memory with a faster response time than said main memory;
second memory means for storing the information related to an address of said instructions and\or said data stored in said first memory means;
first detection means for detecting the relation between said information stored in said second memory means and the address signal supplied from said first signal transmission path to determine one of a hit of correlation between said information stored in said second memory means with the address supplied and a miss corresponding to a lack of correlation between said information stored in said second memory means with the address supplied from said first signal transmission path;
control means for transmission of said instructions and/or said data stored in said first memory means to said processor through said second signal transmission path and said second terminal in response to the detection of a hit by said first detection means;
said control means reading out the instructions and/or data related to said address signal from main memory in response to detection of a miss by said first detection means and transmitting the read-out instruction and/or data to said processor through said second signal transmission path and said second terminal, and storing the read-out instructions and/or data in said first memory means;
terminal means for receiving a control signal from outside said single chip cache memory device; and
said control means, in response to a fixed condition of said control signal, inhibiting at least one of said reading out of said instructions and/or data from said main memory and storing of the read out instructions and/or data information into said first memory means, and substantially simultaneously maintaining the memory operations of said first and second memory means so that a plurality of said single chips may be combined as a cache memory apparatus.

2. A single chip cache memory device according to claim 1 further comprising:
transmission means for transmitting the instructions and/or data of said second signal transmission path to said second terminal;
said control means inhibiting signal transmission of said transmission means when said control signal is under said fixed condition.

3. A signal chip cache memory device according to claim 1, wherein said control means includes a decoder means for generating said control signal.

4. A signal chip cache memory device according to claim 1, wherein said terminal means for receiving a control signal is a chip select terminal.

5. A single chip cache memory device according to claim 1, said first detection means receives the address from said first terminal means as originating with the processor;
second detecting means for detecting the correlation of said information stored in said second memory means and an external address signal supplied from outside said single cache memory device to said third terminal means to provide a hit signal and further to provide a miss signal in response to lack of correlation;
said control means, in response to a hit signal from said second detection means, invalidating said information in said second memory means corresponding to the address supplied to said second detection means from said third terminal when information is written to said main memory by a device different from said processor.

6. A chip cache memory device according to claim 5, wherein: further including:
transmission means for transmitting the instructions and/or data of said second signal transmission path to said second terminal;
said control means inhibiting signal transmission of said transmission means when said control signal is under said fixed condition.

7. A single chip cache memory device to be connected in parallel with other like devices for constituting a cache memory apparatus to be disposed between a processor for processing instructions and/or data and a main memory for storing said instructions and/or data, said single chip cache memory device comprising: first memory means for storing temporarily said instructions and/or said data stored in said main memory with a faster response time than said main memory; -
second memory means for storing the information related to an address of said instructions and\or said data stored in said first memory means;
first detection means for detecting the relation between said information stored in said second memory means and the address signal supplied from said processor to determine one of a hit with correlation between said information stored in said second memory means with the address supplied and a miss corresponding to a lack of correlation between said information stored in said second memory means with the address signal supplied from said processor;
control means for transmitting said instructions and/or said data stored in said first memory means to said processor in response to the detection of a hit by said first detection means;
means for receiving a chip control code signal from outside said single chip cache memory device and having different fixed conditions corresponding respectively to selection of the parallel devices; and
said control means reading out the instructions and/or data related to said address signal from said main memory in response to detection of a miss by said first detection means and in response to only one of the fixed conditions of the chip control code signal, and storing the read out instructions and/or data in said first memory means; so that a plurality of said single chip devices may be combined in a single cache memory without duplication of function.

8. A single chip cache memory device according to claim 7 further comprises:
transmission means for transmitting the instructions and/or data from the main memory to the processor;
said control means inhibiting signal transmission of said transmission means when said control code signal is not receiving said one fixed condition of the chip code control signal.

9. Cache memory device according to claim 8, further comprising hold memory means for storing the instructions and/or data and corresponding address from the processor for transmission to the main memory and providing an acknowledge signal to free the processor from the memory write; and
said control means being responsive to said control code signal to control said hold memory means to inhibit transmission to said main memory until receiving a memory-ready signal from said main memory.

10. A single chip cache memory device according to claim 7, further comprising hold memory means for storing the instructions and/or data and corresponding address from the processor for transmission to the main memory and providing an acknowledge signal to free the processor from the memory write; and
said control means being responsive to said control code signal to control said hold memory means to inhibit transmission to said main memory until receiving a memory-ready signal from said main memory.

11. A single chip cache memory device according to claim 7, wherein:
said first detection means receives the address signal only from the processor;
second detecting means for detecting the correlation of said information stored in said second memory means and an external address signal supplied from outside said single cache memory device to provide a hit signal and further to provide a miss signal in response to lack of correlation;
transmission means preventing transmission of the address signal from the processor to said second detection means;
said control means, in response to a hit signal from said second detection means, invalidating said information in said second memory means corresponding to the address supplied through said second detection means when information is written to said main memory from an external device other than the processor.

12. A single chip cache memory device according to claim 5, including means preventing passage of an address signal from said third terminal means to said first detection means; and
means preventing passage of an address signal from said first terminal means to said second detecting means.

13. A single chip cache memory device according to claim 12, wherein: further including:
transmission means for transmitting the instructions and/or data of said second signal transmission path to said second terminal;
said control means inhibiting signal transmission of said transmission means when said control signal is under said fixed condition.

14. A cache memory device to be disposed between a processor for processing instructions and/or data and a main memory for storing said instructions and/or data, said single chip cache memory device comprising:
first memory means for storing temporarily said instructions and/or said data stored in said main memory with a faster response time than said main memory;

second memory means for storing the information related to an address of said instructions and\or said data stored in said first memory means;

first detection means for detecting the relation between said information stored in said second memory means and the address signal supplied from said processor to determine one of a hit of correlation between said information stored in said second memory means with the address supplied and a miss corresponding to a lack of correlation between said information stored in said second memory means with the address signal supplied from said processor;

control means for transmitting said instructions and/or said data stored in said first memory means to said processor in response to the detection of a hit by said first detection means; means for receiving a control signal from outside said cache memory device and transmitting the control signal to said control means; and

said control means reading out the instructions and/or data related to said address signal from said main memory in response to detection of a miss by said first detection means and transmitting the read-out instruction and/or data to said processor, and storing the read out instructions and/or data in said first memory means; and

said control means, in response to a predetermined condition of said control signal, inhibiting at least one of said reading out of said instruction and/or said data from said main memory and storing of the read out instruction and/or data information into said first memory means, and substantially simultaneously maintaining the memory operations of said first and second memory means.

15. A cache memory device according to claim 14 further comprises:

transmission means for transmitting the instructions and/or data from the main memory to the processor;

said control means inhibiting signal transmission of said transmission means when said control code signal is not receiving said one fixed condition of the chip code control signal.

16. A cache memory device according to claim 14, wherein:

said first detection means receives the address signal from the processor;

second detecting means for detecting the correlation of said information stored in said second memory means and an external address signal supplied from outside said cache memory device to provide a hit signal and further to provide a miss signal in response to lack of correlation;

said control means, in response to a hit signal from said second detection means, invalidating said information in said second memory means corresponding to the address supplied through said second detection means when information is written to said main memory from an external device other than the processor.

17. In a data processor having a processor, a main memory and a cache memory apparatus disposed between the processor for processing instructions and/or data and the main memory for storing said instructions and/or said data, said apparatus including a plurality of parallel connected single chip cache memory devices, with each device being formed on a single semiconductor chip and comprising:

first terminal means for communicating an address with said processors;

second terminal means for communicating instructions and/or data with said processor;

third terminal means for communicating the address with said memory;

fourth terminal means for communicating the instructions and/or data with said main memory;

a first signal transmission path between said first terminal means and said third terminal means;

a second signal transmission path between said second terminal means and said fourth terminal means;

first memory means for storing temporarily said instructions and/or said data stored in said main memory with a faster response time than said main memory;

second memory means for storing the information related to an address of said instructions and\or said data stored in said first memory means;

first detection means for detecting the relation between said information stored in said second memory means and the address signal supplied from said first signal transmission path to determine one of a hit of correlation between said information stored in said second memory means with the address supplied and a miss corresponding to a lack of correlation between said information stored in said second memory means with the address signal supplied from said first signal transmission path;

control means for transmission of said instructions and/or said data stored in said first memory means to said processor through said second signal transmission path and said second terminal in response to the detection of a hit by said first detection means;

said control means reading out the instructions and/or data related to said address signal from said main memory in response to detection of a miss by said first detection means and transmitting the read out instruction and/or data to said processor through said second signal transmission path and said second terminal, and storing the read out instructions and/or data in said first memory means;

terminal means for receiving a control signal from outside said single chip cache memory device; and said control means, in response to a fixed condition of said control signal, inhibiting at least one of said reading out of said instructions and/or said data from said main memory and storing of the read out instructions and/or data information into said first memory means, and substantially simultaneously maintaining the memory operations of said first and second memory means so that a plurality of said single chips may be combined as a cache memory;

said processor supplying said address with an address code portion specifying said control signal and thereby selecting only one out of said plurality of cache memory devices;

said control means being responsive to information supplied by said code portion of said address to select the code portion identified one of said plurality of cache memory devices for controlling read out of said instructions and/or some data from said main memory so that write in of said read-out information occurs only in said first memory means of the selected one of said plurality of cache memory devices and is inhibited in the other of said cache memory devices whose code is not specified in said address.

18. A cache memory apparatus according to claim 17, wherein each of said plurality of said single chip cache memory devices further comprises:

transmission means for transmitting the instructions and/or data of said second signal transmission path to said second terminal;

said control means inhibiting signal transmission of said transmission means when said control signal is under said fixed condition.

19. A cache memory apparatus according to claim 8, wherein said first detection means receives the address from said first terminal means as originating with the processor;

second detecting means for detecting the correlation of said information stored in said second memory means and an external address signal supplied from outside said single cache memory device to said third terminal means to provide a hit signal and further to provide a miss signal in response to lack of correlation; and

said control means, in response to a hit signal from said second detection means, invalidating said information in said second memory means corresponding to the address supplied to said second detection means from said third terminal when information is written to said main memory device different from said processor.

20. A cache memory apparatus according to claim 17, wherein said first detection means receives the address only from said first terminal means as originating with the processor;

second detecting means for detecting the correlation of said information stored in said second memory means and only an external address signal supplied from outside said single cache memory device to said third terminal means to provide a hit signal and further to provide a miss signal in response to lack of correlation;

transmission means preventing transmission of the address signal from said processor through said first terminal to said second detection means; and

said control means, in response to a hit signal from said second detection means, invalidating said information in said second memory means corresponding to the address supplied to said second detection means from said third terminal when information is written to said main memory device external from said processor.

21. A cache memory apparatus according to claim 17, further including a mode terminal leading to said control means, for receiving a mode signal from outside the cache memory apparatus; said control means being responsive to the mode signal provided to said mode terminal for decoding the mode signal to provide an indication of the number of cache chips employed in the apparatus in parallel.

22. A cache memory apparatus according to claim 21, further including a position terminal providing position information from outside the cache memory apparatus to said control means; said control means being responsive to said position signal for decoding said position signal to provide an indication of the position of the chip within the plurality of chips connected in parallel;

said control means combining the position indication and the mode indication and comparing information from the same with decode bits from the address signal.

23. A cache memory apparatus according to claim 20, wherein:

further including a mode terminal leading to said control means, for receiving a mode signal from outside the single semiconductor chip; said control means being responsive to the mode signal provided to said mode terminal for decoding the mode signal to provide an indication of the number of cache chips employed in the apparatus in parallel;

further including a position terminal providing position information from outside the single semiconductor chip to said control means; said control means being responsive to said position signal for decoding said position signal to provide an indication of the position of the chip within the plurality of chips connected in parallel;

said control means combining the position indication and the mode indication and comparing information from the same with decode bits from the address signal.

24. A cache memory apparatus according to claim 23, wherein said control means watches the address of the main memory bus under both conditions of hit and miss-hit as a part of said memory operations;

each of said cache chips including a data register means in the second transmission path between the processor and the main memory and a address register in the first transmission path between the processor and main memory; each of said cache chips being connected between said main memory and said processor so that the processor writes data into the main memory only through the cache chips, with the data address being stored in the address register means and the data being stored in the data register means of the cache chip selected according to the control signal, said data register means and address register means storing respectively the data and address in response to a main memory busy signal and said control means provides acknowledgment signal to said processor indicating that the write operation to the main memory is complete; said control means of the selected cache chip further providing memory bus request signals to said main memory for transferring the data held by the data register means and the address held by said address register means in response to a memory bus acknowledgment signal when the main memory is no longer busy.

25. A cache memory apparatus according to claim 17, wherein:

further including a mode terminal leading to said control means, for receiving a mode signal from outside the chip; said control means being responsive to the mode signal provided to said mode terminal for decoding the mode signal to provide an indication of the number of cache chips employed in the apparatus in parallel;

further including a position terminal providing position information from the processor to said control means; said control means being responsive to said position signal for decoding said position signal to provide an indication of the position of the control chip within the plurality of chips connected in parallel;

said control means combining the position indication and the mode indication and comparing information from the same with decode bits from the address signal.

# FIG. 1

EP 0 335 113 A2

# FIG. 2

ADDRESS BITS

31 ... 27 ... 15 ... 7 ... 0

| TAG FIELD | COLUMN FIELD | | | BYTE FIELD |

DECODE FIELD

WORD FIELD

# FIG. 4

581 582 583 584 585 586 587 588 901

90

902
903
900
ACCESS CONTROL CKT
913
914
918
IHIT
REF
915
916
917
REF
INVALIDATION
CONTROL CKT

HIT
CS — 906
AS — 907
R/W — 908
DTACK
905
912
904
RDY
909
911
910
MREQ
DTACK

FIG. 3

## FIG. 5

## FIG. 6

FIG. 7

# FIG. 8

# FIG. 9